# FASCICULE DE BREVET EUROPEEN

(11) **EP 3 806 162 B1**
(45) Date de publication et mention de la délivrance du brevet: **10.01.2024**
(21) Numéro de dépôt: 20199744.2
(22) Date de dépôt: 02.10.2020
(51) Int. Cl.: H01L 31/02, G01J 1/44

(54) **EXTINCTION D'UNE SPAD**
LÖSCHSCHALTUNG EINER SPAD
QUENCHING OF A SPAD

(30) Priorité: 07.10.2019 FR 1911063
(43) Date de publication de la demande: 14.04.2021
(73) Titulaire: STMicroelectronics (Research & Development) Limited, Buckinghamshire SL7 1EY (GB); STMicroelectronics Crolles 2 SAS, 38920 Crolles (FR)
(72) Inventeur: BIANCHI, Raul Andres, 73800 Myans (FR); VIGNETTI, Matteo Maria, 73100 Aix les Bains (FR); RAE, Bruce, Edinburgh EH10 6UX (GB)
(74) Mandataire: Cabinet Beaumont

(56) Documents cités:
- EP-A1- 3 503 534
- US-A1- 2019 113 385
- MINGGUO LIU ET AL: "Reduce Afterpulsing of Single Photon Avalanche Diodes Using Passive Quenching With Active Reset", IEEE JOURNAL OF QUANTUM ELECTRONICS, IEEE SERVICE CENTER, PISCATAWAY, NJ, USA, vol. 44, no. 5, 1 mai 2008 (2008-05-01), pages 430-434, XP011205180, ISSN: 0018-9197
- ANDREA GALLIVANONI ET AL: "Progress in Quenching Circuits for Single Photon Avalanche Diodes", IEEE TRANSACTIONS ON NUCLEAR SCIENCE, IEEE SERVICE CENTER, NEW YORK, NY, US, vol. 57, no. 6, 1 décembre 2010 (2010-12-01), pages 3815-3826, XP011339767, ISSN: 0018-9499, DOI: 10.1109/TNS.2010.2074213
- BERDALOVIC I ET AL: "Design of passive-quenching active-reset circuit with adjustable hold-off time for single-photon avalanche diodes", 2016 39TH INTERNATIONAL CONVENTION ON INFORMATION AND COMMUNICATION TECHNOLOGY, ELECTRONICS AND MICROELECTRONICS (MIPRO), CROATIAN SOCIETY MIPRO, 30 mai 2016 (2016-05-30), pages 34-39, XP032929435, DOI: 10.1109/MIPRO.2016.7522106
- F. LIN ET AL: "<title>A photon-counting avalanche photodiode array with fully integrated active quenching and recharging circuit</title>", PROCEEDINGS OF SPIE/ IS & T, vol. 5826, 3 juin 2005 (2005-06-03), pages 569-579, XP055222873, US DOI: 10.1117/12.604846 ISBN: 978-1-62841-730-2

## Description

### Domaine technique

La présente description concerne de façon générale les circuits électroniques, et plus particulièrement les diodes à avalanche à photon unique ("Single Photon Avalanche Diode") ou SPAD.

### Technique antérieure

Pour détecter un photon unique, une diode ou photodiode SPAD est polarisée en inverse à une tension supérieure (en valeur absolue) à sa tension d'avalanche, ou dit autrement, la diode est en condition Geiger, ou mode Geiger. Dans ce mode, lorsqu'un photon unique atteint la diode, les porteurs libres photogénérés à partir de ce photon unique sont suffisamment accélérés par le champ électrique présent au niveau de la jonction de la diode pour créer des porteurs libres supplémentaires. La diode entre alors en avalanche et un courant circule dans la diode. Pour détecter à nouveau un photon unique, la diode doit alors être éteinte ("quenched" en anglais) en abaissant la tension à ses bornes en dessous de sa tension d'avalanche (en valeur absolue) pour vider la diode de ses porteurs libres, puis être replacée en condition Geiger. Un circuit d'extinction ("quench circuit" en anglais) est prévu à cet effet. Le document US2019113385 A1 et la publication "Reduce afterpulsing of single photon avalanche diodes using passive quenching with active reset" de Liu Mingguo et al., IEEE Journal of quantum electronics, vol. 44, n°5, May 2008, divulguent des exemples connus de dispositifs présentant les circuits de lecture et d'extinction associés à une photodiode avalanche.

### Résumé de l'invention

Il existe un besoin d'un dispositif comprenant une SPAD et un circuit d'extinction associé à la SPAD qui pallie tout ou partie des inconvénients des dispositifs connus comprenant une SPAD et un circuit d'extinction associé à la SPAD.

Il existe notamment un besoin d'un dispositif comprenant une SPAD et son circuit d'extinction qui soit compact, par exemple pour réaliser un capteur d'images compact comprenant plusieurs de ces dispositifs, par exemple agencés en matrice.

Il existe également un besoin d'un dispositif comprenant une SPAD et un circuit d'extinction associé à la SPAD qui permette de diminuer le temps mort ("dead time" en anglais) entre deux détections successives de photons uniques par rapport aux dispositifs connus comprenant une SPAD et un circuit d'extinction associé à la SPAD.

Le dispositif de l'invention est défini par la revendication 1 et pallie tout ou partie des inconvénients des dispositifs connus comprenant une SPAD et un circuit d'extinction associé à cette SPAD.

Un mode de réalisation prévoit un dispositif comprenant :
une photodiode dont une première borne est reliée par une résistance à un premier noeud configuré pour recevoir un potentiel haut d'alimentation et dont une deuxième borne est reliée par un interrupteur, de préférence un transistor MOS,
à un deuxième noeud configuré pour recevoir un potentiel de référence ;
un circuit de lecture configuré pour fournir une impulsion lorsque la diode entre en avalanche ; et
un circuit de commande configuré pour commander une ouverture de l'interrupteur en réponse au début de ladite impulsion et pour commander une fermeture de l'interrupteur en réponse à la fin de ladite impulsion.

Selon un mode de réalisation, le circuit de commande comprend une porte logique comprenant une entrée configurée pour recevoir ladite impulsion et une sortie configurée pour fournir un signal de commande de l'interrupteur.

Selon un mode de réalisation, le circuit de commande est en outre configuré pour contrôler la pente du signal de commande en fonction d'une valeur d'un potentiel de réglage de pente, lors d'une commutation du signal de commande entraînant une fermeture l'interrupteur.

Selon un mode de réalisation, le circuit de commande comprend un transistor MOS connecté entre une borne d'alimentation du circuit de commande et une première borne d'alimentation de la porte du circuit de commande, une grille du transistor MOS étant configurée pour recevoir le potentiel de réglage de pente.

Selon un mode de réalisation, le dispositif est configuré pour interrompre un chemin conducteur reliant la deuxième borne de la diode au deuxième noeud via l'interrupteur tant qu'un signal de désactivation du dispositif est dans un premier état.

Selon un mode de réalisation :
- un interrupteur supplémentaire commandé par le signal de désactivation du dispositif est connecté en série avec ledit interrupteur entre la deuxième borne de la diode et le deuxième noeud ; ou
- la porte du circuit de commande comprend une entrée configurée pour recevoir le signal de désactivation du dispositif.

Selon un mode de réalisation, le circuit de commande est en outre configuré pour maintenir l'interrupteur fermé tant qu'un signal de désactivation du circuit de commande est dans un premier état, de préférence, la porte du circuit de commande comprenant une entrée configurée pour recevoir le signal de désactivation du circuit de commande.

Selon un mode de réalisation, le circuit de commande comprend un transistor MOS connecté entre une deuxième borne d'alimentation de la porte du circuit de commande et le deuxième noeud, une grille du transistor étant configurée pour recevoir un signal de désactivation du circuit de commande.

Selon un mode de réalisation, le circuit de lecture est en outre configuré pour modifier une durée de l'impulsion en fonction d'une valeur d'un potentiel de réglage de durée d'impulsion.

Selon un mode de réalisation, le circuit de lecture comprend un transistor MOS connecté entre une borne d'alimentation du circuit de lecture et le noeud intermédiaire, une grille du transistor MOS étant configurée pour recevoir le potentiel de réglage de durée d'impulsion.

Selon un mode de réalisation, le circuit de lecture comprend une porte logique, de préférence un inverseur, comprenant une borne d'entrée reliée, de préférence connectée, au noeud intermédiaire, et une borne de sortie configurée pour fournir ladite impulsion.

Selon un mode de réalisation, le circuit de lecture et le circuit de commande sont connectés chacun entre le deuxième noeud et un troisième noeud configuré pour recevoir un potentiel bas d'alimentation.

Selon un mode de réalisation, le dispositif comprend en outre un circuit de limitation de potentiel configuré pour limiter un niveau maximal de potentiel sur la deuxième borne de la diode, de préférence, le circuit de limitation de potentiel comprenant une diode supplémentaire connectée entre la deuxième borne de ladite diode et un noeud configuré pour recevoir un potentiel intermédiaire d'alimentation.

Selon un mode de réalisation, le dispositif comprend en outre une capacité connectée entre la deuxième borne de ladite diode et le deuxième noeud.

Un autre mode de réalisation prévoit un capteur d'images comprenant une pluralité de dispositifs tels que ci-dessus, de préférence agencés en matrice, chaque dispositif formant de préférence un pixel du capteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, sous la forme d'un circuit, un mode de réalisation d'un dispositif comprenant une diode adaptée à une utilisation comme SPAD, et un circuit d'extinction de la diode ;
la figure 2 représente des chronogrammes A et B illustrant le fonctionnement d'un mode de réalisation du dispositif de la figure 1 ;
la figure 3 représente un chronogramme illustrant le fonctionnement d'un autre mode de réalisation du dispositif de la figure 1 ;
la figure 4 représente un chronogramme illustrant le fonctionnement d'encore un autre mode de réalisation du dispositif de la figure 1 ;
la figure 5 représente une variante de réalisation du dispositif de la figure 1 ;
la figure 6 représente une autre variante de réalisation du dispositif de la figure 1 ;
la figure 7 représente encore une autre variante de réalisation du dispositif de la figure 1 ; et
la figure 8 représente encore une autre variante de réalisation du dispositif de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de comptage d'impulsions générées par un circuit de lecture d'une SPAD à chaque détection d'un photon unique, c'est-à-dire à chaque fois que la SPAD en condition Geiger entre en avalanche après avoir été frappée par un photon, n'ont pas été détaillés, les modes de réalisation décrits étant compatibles avec les circuits usuels de comptage d'impulsions. En outre, la mise en oeuvre d'un capteur d'images comprenant une pluralité de dispositifs, ou pixels, chacun munis d'une SPAD, n'a pas été détaillée, les modes de réalisation décrits étant compatibles avec de tels capteurs d'images usuels. Plus généralement, les diverses applications où sont prévues une ou plusieurs SPAD pour détecter des photons uniques n'ont pas été détaillées, les modes de réalisation décrits étant compatibles avec ces applications usuelles. Par ailleurs, les mises en oeuvre pratiques d'une diode adaptée à une utilisation en tant que SPAD n'ont pas été détaillées, les modes de réalisation décrits étant compatibles avec les mises en oeuvre usuelles d'une diode adaptée à une utilisation en tant que SPAD.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

On appelle "signal numérique" un signal qui alterne entre au moins deux états constants, par exemple entre un état bas, noté "0", et un état haut, noté "1", pour un "signal binaire". En pratique, un signal numérique peut correspondre à un potentiel référencé par rapport à un potentiel de référence, typiquement la masse GND, ou à un courant qui peuvent ne pas être parfaitement constants pour un état donné du signal. Dans la suite de la description un premier état d'un premier signal peut correspondre à un état bas du signal alors que le premier état d'un deuxième signal peut correspondre à un état haut du signal, les premiers états des premier et deuxième signaux pouvant alors correspondre à des niveaux de potentiels différents.

Il existe deux types de circuits d'extinction, à savoir les circuits d'extinction de type passif et les circuits d'extinction de type actif. Un circuit d'extinction passif comprend une résistance en série avec la SPAD de sorte que, une fois l'avalanche dans la SPAD déclenchée, la diminution de la tension (en valeur absolue) aux bornes de la SPAD résulte directement de la chute de tension dans la résistance. Un circuit d'extinction actif comprend des moyens pour réduire la tension aux bornes de la SPAD en dessous de la tension d'avalanche (en valeur absolue) suite à la détection d'une avalanche dans la SPAD. En particulier, un circuit d'extinction actif comprend des composants tels que des transistors, qui sont alimentés par et/ou reçoivent des potentiels ayant des valeurs de l'ordre de celle de la tension aux bornes de la SPAD en mode Geiger.

Dans la suite de la description on s'intéresse plus particulièrement à des modes de réalisation dans lesquels le début du processus d'extinction de la SPAD est passif, c'est-à-dire qu'il démarre directement après la chute de tension dans une résistance connectée en série avec la diode SPAD. Le processus d'extinction se poursuit ensuite dans des conditions de tension et de durée déterminées par un circuit de commande ou de contrôle qui gouverne également la phase de remise à l'état initial du système.

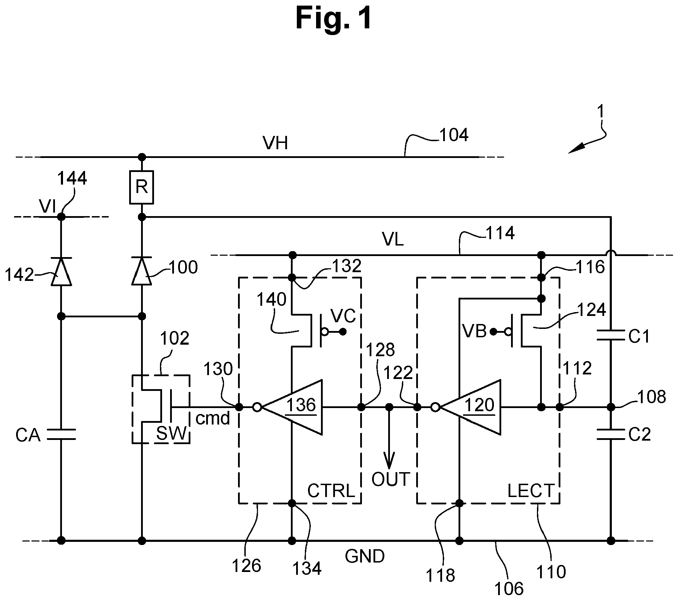

La figure 1 représente, sous la forme d'un circuit, un mode de réalisation d'un dispositif 1 comprenant une diode 100 adaptée à une utilisation comme SPAD, et un circuit d'extinction de la diode 100.

Le dispositif 1 comprend une résistance R et un interrupteur 102 ("SW"). La résistance R relie une première borne de la diode 100, de préférence sa cathode, à un premier rail, ou noeud ou conducteur électrique, 104 destiné à recevoir un potentiel haut d'alimentation VH. De préférence, une borne de la résistance R est connectée au rail 104, et une deuxième borne de la résistance R est connectée à la cathode de la diode 100. L'interrupteur 102 relie une deuxième borne de la diode 100, de préférence son anode, à un deuxième rail, ou noeud ou conducteur électrique, 106 destiné à recevoir un potentiel de référence GND, typiquement la masse. Le potentiel VH est référencé à la masse GND. Le potentiel VH est de préférence positif, par exemple environ égal à 25 V.

Selon un mode de réalisation, l'interrupteur 102 est mis en oeuvre par un transistor MOS 102, de préférence un transistor MOS à canal N. Les bornes de conduction de l'interrupteur 102 correspondent alors aux bornes de conduction respectives du transistor 102, c'est-à-dire aux bornes de drain et de source du transistor 102. En outre, une borne de commande de l'interrupteur 102 correspond alors à une borne de commande, ou grille, du transistor 102.

Selon le mode de réalisation illustré par la figure 1, les bornes de conduction de l'interrupteur 102 sont connectées respectivement à la deuxième borne (anode) de la diode 100 et au deuxième rail 106. Par exemple, le drain du transistor 102 est connecté à l'anode de la diode 100, et la source du transistor 102 est connectée au rail 106.

Le dispositif 1 comprend un pont diviseur capacitif connecté entre la cathode de la diode 100 et le rail 106. Le pont diviseur capacitif comprend un noeud intermédiaire 108. Le pont diviseur capacitif est configuré pour qu'une variation du potentiel de cathode de la diode 100 entraîne une variation du potentiel du noeud 108.

Dans cet exemple, le pont diviseur capacitif comprend deux capacités C1 et C2 en série entre la cathode de la diode 100 et le rail 106. La capacité C1 est reliée, de préférence connectée, à la diode 100, la capacité C2 étant reliée, de préférence connectée, au rail 106, et les capacités C1 et C2 étant connectées l'une à l'autre au niveau du noeud 108.

Le dispositif 1 comprend un circuit de lecture 110 ("LECT"). Le circuit 110 (délimité par un cadre en pointillés en figure 1) est configuré pour fournir un signal de sortie OUT du dispositif 1. Plus particulièrement, le circuit 110 est configuré pour fournir une impulsion à chaque avalanche dans la diode 100. Dit autrement, à chaque avalanche dans la diode 100, le circuit 110 est configuré pour que le signal OUT commute d'un premier état, par exemple l'état bas, à un deuxième état, par exemple l'état haut, puis, après une durée donnée, pour que le signal OUT commute du deuxième état au premier état. Une borne d'entrée 112 du circuit de lecture 110 est connectée au noeud 108.

Selon un mode de réalisation, le circuit 110 reçoit un potentiel bas d'alimentation VL, le potentiel VL étant, comme le potentiel VH, référencé à la masse GND et de préférence positif. La notion de potentiel bas VL et de potentiel haut VH est une notion relative de ces deux potentiels l'un par rapport à l'autre, le potentiel VL étant inférieur au potentiel VH. Le circuit 110 est connecté entre un troisième rail, ou noeud ou conducteur électrique, 114 d'application du potentiel VL et le rail 106. Dit autrement, une borne 116 d'alimentation du circuit 110, par exemple une borne d'alimentation haute, est connectée au rail 114, une autre borne 118 d'alimentation du circuit 110, par exemple une borne d'alimentation basse destinée à recevoir un potentiel de préférence plus faible que celui reçu par la borne d'alimentation haute, étant connectée au rail 106. Le potentiel VL est par exemple positif, par exemple de l'ordre de 1,1 V.

Selon un mode de réalisation, le circuit 110 comprend une porte logique 120, de préférence un inverseur, comprenant une entrée reliée, de préférence connectée, à la borne 112, donc au noeud 108, et une sortie 122 configurée pour fournir le signal OUT et correspondant à la borne de sortie du circuit 110. La porte 120 comprend des première et deuxième bornes d'alimentation, par exemple respectivement haute et basse, reliées, de préférence connectées, aux bornes d'alimentation respectivement 116 et 118 du circuit de lecture 110.

Selon un mode de réalisation, le circuit 110 est configuré pour modifier la durée, ou largeur, de l'impulsion du signal OUT, en fonction d'une valeur d'un potentiel VB de réglage de durée d'impulsion. Le potentiel VB est ici référencé à la masse GND et est par exemple compris entre le potentiel VL et 0 V. De préférence, le circuit 110 comprend alors un transistor MOS 124, de préférence un transistor MOS à canal P, connecté entre la borne 116 et le noeud 108, la grille du transistor 124 étant configurée pour recevoir le potentiel VB. La valeur du potentiel VB et le transistor 124 permettent de fixer la durée des impulsions du signal OUT. Dans cet exemple, plus la valeur du potentiel VB est faible, plus l'impulsion est courte.

Le dispositif 1 comprend un circuit 126 de commande ("CTRL") de l'interrupteur 102. Le circuit 126 est configuré pour commander une ouverture de l'interrupteur 102 en réponse au début d'une impulsion du signal OUT (commutation du signal OUT de son premier état à son deuxième état) et pour commander une fermeture de l'interrupteur 102 en réponse à la fin de l'impulsion (commutation du signal OUT de son deuxième état à son premier état). Une borne d'entrée 128 du circuit est reliée, de préférence connectée, à la borne de sortie 122 du circuit 110. Une borne de sortie 130 du circuit 126 est configurée pour fournir un signal de commande cmd de l'interrupteur 102, la borne 130 étant reliée, de préférence connectée, à la borne de commande de l'interrupteur 102. Plus particulièrement, le circuit 126 est configuré pour commuter le signal cmd d'un premier état pour lequel l'interrupteur 102 est fermé, par exemple l'état haut, à un deuxième état pour lequel l'interrupteur 102 est ouvert, par exemple l'état bas, en réponse au début d'une impulsion du signal OUT, et, inversement, pour commuter le signal de commande de l'interrupteur 102 du deuxième état au premier état en réponse à la fin de l'impulsion du signal OUT.

Selon un mode de réalisation, le circuit 126 reçoit le potentiel d'alimentation VL. Dit autrement, le circuit 126 est connecté entre les rails 114 et 106. Dit encore autrement, une borne 132 d'alimentation du circuit 126, par exemple une borne d'alimentation haute, est connectée au rail 114, une autre borne 134 d'alimentation du circuit 126, par exemple une borne d'alimentation basse, étant connectée au rail 106.

Selon un mode de réalisation, le circuit 126 comprend une porte logique 136, dans l'exemple représenté un inverseur, comprenant une entrée reliée, de préférence connectée, à la borne 128, et une sortie reliée, de préférence connectée, à la borne 130, la sortie de la porte 136 étant configurée pour fournir le signal cmd. La porte 136 comprend des première et deuxième bornes d'alimentation, par exemple respectivement haute et basse, reliées aux bornes d'alimentation respectivement 132 et 134.

Selon un mode de réalisation, le circuit 126 est configuré pour contrôler, ou modifier, la pente du signal cmd en fonction de la valeur d'un potentiel VC de réglage de pente, lors d'une commutation du signal cmd entraînant une commutation de l'interrupteur 102 à l'état fermé. De préférence, le circuit 126 comprend alors un transistor MOS 140, de préférence un transistor MOS 140 à canal P, connecté entre la borne d'alimentation 132 du circuit 126 et la borne d'alimentation correspondante de la porte 136 du circuit 126, c'est-à-dire la borne d'alimentation de la porte 136 configurée pour recevoir le niveau de potentiel correspondant au premier état du signal cmd. Ainsi, plus la valeur du potentiel VC est basse par rapport à celle du potentiel VL, par exemple plus la valeur du potentiel VC est proche de 0 V, plus la pente du signal cmd lors d'une commutation à son premier état est forte, et plus l'interrupteur 102 commute rapidement à son état fermé.

La prévision d'une pente relativement faible, par exemple une pente de l'ordre de 0,1 Vins, lors d'une commutation du signal cmd permet une fermeture progressive de l'interrupteur 102, ce qui évite des déclenchements non désirés, ou intempestifs, d'avalanche dans la diode 100 lorsque cette dernière est en train d'être replacée en condition Geiger. Cela permet en outre de limiter les perturbations sur le noeud 108, et donc d'éviter des fausses détections par le circuit 110. En outre, en réduisant la pente de cette commutation du signal cmd, on augmente le retard entre la fin d'une impulsion du signal OUT sur la borne 128 et la fermeture correspondante de l'interrupteur 102.

Selon un mode de réalisation, le dispositif 1 comprend un circuit 142 configuré pour limiter le niveau maximal du potentiel sur l'anode de la diode 100. Dans cet exemple, le circuit 142 est une diode 142 connectée entre l'anode de la diode 100 et un noeud 144 d'application d'un potentiel intermédiaire d'alimentation VI référencé à la masse GND et de préférence positif. La notion de potentiel haut VH, de potentiel bas VL et de potentiel intermédiaire VI est une notion relative de ces potentiels les uns par rapport aux autres, le potentiel VI étant compris entre les potentiels VH et VL. L'anode de la diode 142 est de préférence connectée à l'anode de la diode 100 et la cathode de la diode 142 est de préférence connectée au noeud 144. Le potentiel VI est par exemple positif, par exemple de l'ordre de 7 V.

La prévision du circuit 142 permet d'éviter que la tension aux bornes de l'interrupteur 102 à l'état ouvert atteigne des valeurs susceptibles d'entraîner la destruction de l'interrupteur 102, dans cet exemple la destruction du transistor 102.

Selon un mode de réalisation, le dispositif 1 comprend une capacité CA connectée entre l'anode de la diode 100 et le rail 106.

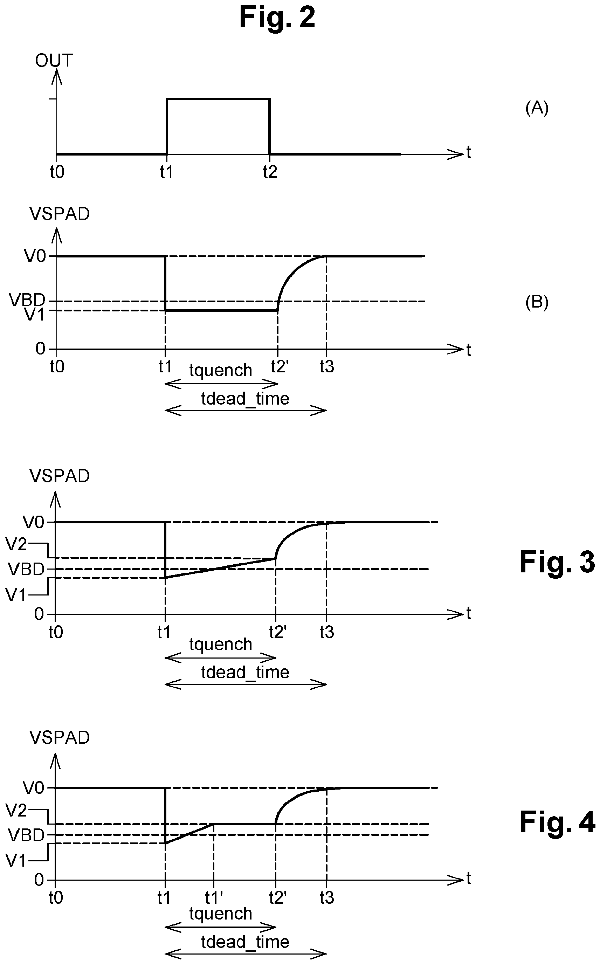

Le fonctionnement du dispositif 1 va maintenant être décrit en relation avec les figures 2 à 5, chacune des figures 2 à 5 illustrant le fonctionnement d'un mode de réalisation différent du dispositif 1.

La figure 2 représente des chronogrammes A et B illustrant le fonctionnement d'un mode de réalisation du dispositif de la figure 1. Le chronogramme A illustre l'évolution du signal OUT en fonction du temps t, le chronogramme B illustrant l'évolution, en fonction du temps t, de la tension VSPAD correspondant à la différence entre le potentiel de cathode de la diode 100 et le potentiel d'anode de la diode 100. Les chronogrammes A et B ne sont pas tracés à l'échelle.

En figure 2, on considère un mode de réalisation du dispositif 1 dans lequel la valeur de la capacité CA est négligeable ou dans lequel la capacité CA est omise, c'est-à-dire un mode de réalisation dans lequel l'anode de la diode 100 est considérée comme flottante quand l'interrupteur 102 est ouvert.

A un instant t0, la diode 100 est en condition Geiger. Autrement dit, la tension VSPAD est à une valeur V0 supérieure à celle de la tension d'avalanche VBD de la diode 100 (en valeur absolue) et aucun courant ne circule dans la diode 100. La valeur V0 est par exemple sensiblement égale à celle du potentiel VH.

En outre, le potentiel sur l'entrée 112 du circuit 110 est à une valeur haute suffisante pour que le signal OUT soit à une valeur basse (premier état du signal OUT). A titre d'exemple, la valeur haute du potentiel sur l'entrée 112 est au moins en partie déterminée par le ratio des capacités C1 et C2. La valeur haute du potentiel sur l'entrée 112 est au moins en partie déterminée par la valeur du potentiel VB dans les modes de réalisation où le circuit 110 est configuré pour modifier la largeur des impulsions du signal VOUT en fonction de la valeur du potentiel VB.

Le premier état du signal OUT sur l'entrée 128 du circuit 126 entraîne que le signal cmd est à son premier état, par exemple l'état haut du signal cmd, et que l'interrupteur 102 est fermé.

A un instant t1 postérieur à l'instant t0, un photon est reçu par la diode 100 et provoque une avalanche dans la diode 100. Un courant circule entre les rails 104 et 106, à travers la résistance R, la diode 100 et l'interrupteur fermé 102. La chute de tension aux bornes de la résistance R entraîne une baisse correspondante du potentiel de cathode de la diode 100, donc de la tension VSPAD à une valeur V1 inférieure (en valeur absolue) à la tension d'avalanche VBD. Cette diminution de la tension VSPAD à la valeur V1 permet d'éteindre l'avalanche dans la diode 100. Dans le même temps, la baisse du potentiel de cathode de la diode 100 entraîne une baisse du potentiel sur l'entrée 112 du circuit 110 à une valeur telle que le signal OUT commute à une valeur haute (deuxième état du signal OUT). Cette commutation du signal OUT correspond au début d'une impulsion du signal OUT et le circuit 126 commande alors l'ouverture de l'interrupteur 102, en commutant le signal cmd à son deuxième état, par exemple l'état bas du signal cmd.

A partir de l'instant t1, le potentiel de cathode de la diode 100 augmente progressivement via la charge du circuit RC comprenant la résistance R et le pont diviseur capacitif C1, C2.

A un instant t2 postérieur à l'instant t1, le potentiel de cathode de la diode 100 atteint une valeur telle que la valeur du potentiel sur l'entrée 112 du circuit 110 est suffisante pour que le signal OUT commute de son deuxième état à son premier état (fin de l'impulsion du signal OUT). Le circuit 126 commande alors la fermeture de l'interrupteur 102, en commutant le signal cmd à son premier état. A partir d'un instant t2' postérieur à l'instant t2, l'interrupteur 102 se ferme, de préférence progressivement.

Entre les instants t1 et t2', du fait que l'interrupteur 102 est ouvert, l'anode de la diode 100 est flottante et le potentiel d'anode de la diode 100 suit le potentiel de cathode de la diode 100. Il en résulte que, entre les instants t1 et t2', la tension VSPAD reste égale à la tension V1. La durée tquench entre les instants t1 et t2' est déterminée de manière à éteindre ou stopper le phénomène d'avalanche dans la diode 100, et à évacuer de la diode 100 tous les porteurs libres générés lors de l'avalanche. En outre, l'anode de la diode 100 étant flottante, toute nouvelle avalanche dans la diode 100 est immédiatement avortée. Cette durée tquench est couramment appelée temps d'extinction ("quench time" en anglais).

A partir de l'instant t2', le potentiel d'anode de la diode 100 s'approche de celui du rail 106, de préférence progressivement au fur et à mesure que l'interrupteur 102 se ferme. Dans le même temps, l'augmentation du potentiel de cathode de la diode 100 se poursuit et la tension VSPAD augmente alors progressivement jusqu'à atteindre la valeur V0 à un instant t3 postérieur à l'instant t2'. A partir de l'instant t3, la diode 100 est en condition Geiger, prête à détecter un nouveau photon unique. La durée tdead_time entre les instants t1 et t3 nécessaire pour replacer la diode 100 en condition Geiger après le début d'une avalanche dans la diode 100 est couramment appelée temps mort ("dead time" en anglais).

Dans le dispositif 1, le circuit d'extinction de la diode SPAD 100 comprend donc la résistance R, le pont capacitif C1, C2, le circuit de lecture 110, le circuit 126 et l'interrupteur 102.

On considère à titre de comparaison un dispositif fictif similaire au dispositif 1 mais dans lequel le circuit 126 et l'interrupteur 102 seraient omis, et où l'anode de la diode 100 serait connectée au rail 106. Dans un tel dispositif fictif, le temps d'extinction tquench de la diode 100 ne dépendrait que de la constante de temps du circuit RC comprenant la résistance R et le pont diviseur capacitif C1, C2. Il faudrait alors prévoir une résistance R de valeur suffisante pour obtenir un temps d'extinction tquench identique à celui du dispositif 1. Toutefois, cela augmenterait le temps mort tdead_time du dispositif fictif par rapport à celui du dispositif 1, ce qui n'est pas souhaitable.

Ainsi, par rapport à ce dispositif fictif, le dispositif 1 permet de réduire la valeur de la résistance R, donc le temps mort tdead_time, sans modifier le temps d'extinction tquench. Plus généralement, par rapport à un dispositif d'extinction passif usuel, le dispositif 1 permet de réduire la valeur de la résistance R, donc le temps mort tdead_time, tout en conservant le même temps d'extinction tquench. Cet avantage du dispositif 1 par rapport aux dispositifs d'extinction passifs usuels est obtenu en ajoutant uniquement l'interrupteur 102 et le circuit 126, le dispositif 1 restant donc compact, notamment par rapport à des dispositifs d'extinction actifs. En effet, le transistor MOS 102 du dispositif 1 est plus compact et consomme moins que des transistors des circuits d'extinction actifs.

Du fait de sa compacité et de sa faible consommation, le dispositif 1 est adapté à la mise en oeuvre d'un capteur d'images comprenant une pluralité de dispositifs ou pixels 1, de préférence arrangés en matrice. En outre, dans un tel capteur, toutes les SPADs 100 du capteur ont un temps d'extinction tquench indentique et un temps mort tdead_time identique, aux dispersions de fabrication près. Cela résulte notamment du fait que, pour chaque pixel 1, ces temps tquench et tdead_time ne dépendent que de signaux générés directement dans le pixel 1. De plus, dans un tel capteur, la réduction du temps mort tdead_time nécessaire entre deux détections successives de photon unique, permet l'obtention d'une plus grande dynamique que celle d'un capteur d'images dans lequel le temps mort serait plus important, comme ce serait par exemple le cas d'un capteur comprenant une pluralité de dispositifs fictifs tels que décrits ci-dessus.

La figure 3 représente un chronogramme illustrant le fonctionnement d'un autre mode de réalisation du dispositif de la figure 1. Le chronogramme de la figure 3 correspond au chronogramme B de la figure 2 dans le cas d'un mode de réalisation du dispositif 1 où la capacité CA a une valeur non négligeable. Dit autrement, le chronogramme de la figure 3 correspond à un mode de réalisation du dispositif 1 dans lequel, lorsque l'interrupteur 102 est ouvert, les variations du potentiel d'anode de la diode 100 dépendent de la valeur de la capacité CA. Seules les différences de fonctionnement entre ces modes de réalisation du dispositif 1 sont ici mises en exergues.

Par rapport à ce qui a été décrit en relation avec le chronogramme B de la figure 2, en figure 3, entre les instants t1 et t2' le potentiel d'anode de la diode 100 augmente. Plus particulièrement, le potentiel d'anode de la diode 100 augmente moins rapidement que le potentiel de cathode de la diode 100, l'homme du métier étant en mesure de dimensionner les diverses capacités CA, C1 et C2 du dispositif 1 pour obtenir ce fonctionnement. A titre d'exemple, la capacité CA a une valeur comprise entre 0,1 fois la valeur de la capacité interne de la diode 100 et 10 fois la valeur de la capacité interne de la diode 100.

Ainsi, entre les instants t1 et t2', la tension VSPAD augmente depuis la valeur V1 inférieure à celle de la tension d'avalanche VBD (en valeur absolue), jusqu'à une valeur V2.

De préférence, la valeur V2 est supérieure à celle de la tension VBD (en valeur absolue) et inférieure à la valeur V0, et est par exemple égale à (V0+VBD)/2 à plus ou moins (V0-VBD)/4.

La prévision d'une valeur V2 supérieure à celle de la tension VBD permet d'évacuer plus rapidement les porteurs libres générés dans la diode 100 lors de l'avalanche. Cette prévision de la valeur V2 supérieure à celle de la tension VBD permet en outre de s'assurer que tous les porteurs libres générés dans la diode 100 lors de l'avalanche sont bien évacués de la diode 100, y compris dans le cas où la diode 100 aurait tendance à emmagasiner des porteurs en raison de sa structure interne. Le temps d'extinction tquench, donc le temps mort tdead_time, peuvent alors être réduits par rapport au cas de la figure 2, cette réduction étant par exemple mise en oeuvre en modifiant la valeur du potentiel VC et/ou la valeur du potentiel VB. L'homme du métier est en mesure de déterminer la durée tquench pour éteindre l'avalanche dans la diode 100 et la vider de ces porteurs libres générés pendant l'avalanche.

Par ailleurs, entre les instants t1 et t2', l'anode de la diode 100 étant reliée au rail 106 par la faible capacité CA, toute nouvelle avalanche dans la diode 100 n'impliquerait que des courants faibles, donc des variations faibles du potentiel du noeud 112. Ainsi, entre les instants t1 et t2', une nouvelle avalanche ne serait pas détectée par le circuit de lecture 110, mais elle contribuerait à l'évacuation des porteurs libres présents dans la diode 100.

La figure 4 représente un chronogramme illustrant le fonctionnement d'encore un autre mode de réalisation du dispositif de la figure 1. Le chronogramme de la figure 4 correspond au chronogramme de la figure 3 dans le cas d'un mode de réalisation du dispositif 1 où la capacité CA a une valeur non négligeable, et la résistance de l'interrupteur ou transistor 102 à l'état passant a une valeur non nulle, par exemple comprise entre 0,1 fois la valeur de la résistance R et 10 fois la valeur de la résistance R. Seules les différences de fonctionnement entre les dispositifs 1 correspondant aux figures respectives 3 et 4 sont ici mises en exergue.

En figure 4, à l'instant t1, la diminution de la tension VSPAD de la valeur V0 à la valeur V1 résulte non seulement de la chute de tension dans la résistance R, mais aussi de la chute de tension dans l'interrupteur 102 fermé.

Puis, dès que l'interrupteur 102 s'ouvre, le potentiel de cathode de la diode 100 augmente, le potentiel d'anode de la diode 100 augmentant également mais moins rapidement que le potentiel de cathode. La tension VSPAD augmente alors jusqu'à atteindre la valeur V2 à un instant t1' postérieur à l'instant t1 mais antérieur à l'instant t2 correspondant à la fin de l'impulsion du signal OUT. A partir de l'instant t1' jusqu'à l'instant t2', la tension VSPAD est constante et égale à la valeur V2. Cela résulte du fait que l'amplitude de l'augmentation de la tension VSPAD quand l'interrupteur 102 est ouvert est limitée par la valeur de la chute de tension dans la résistance R au moment de l'avalanche, et que cette valeur est plus faible dans le cas de la figure 4 que dans celui de la figure 3.

Par rapport au cas de la figure 3, le mode de réalisation du dispositif 1 décrit en relation avec la figure 4 permet de mieux contrôler la valeur V2 et la durée pendant laquelle la diode 100 est polarisée à la valeur V2. Ceci permet d'éviter que la différence de potentiel aux bornes de la diode 100 se rapproche trop de la valeur V0 entre les instants t1' et t2'. Dit autrement, par rapport au cas de la figure 3, le mode de réalisation du dispositif 1 décrit en relation avec la figure 4 permet de diminuer la probabilité que la diode 100 entre en avalanche de manière intempestive.

L'homme du métier est en mesure choisir la valeur de la résistance R et la valeur de résistance à l'état passant de l'interrupteur ou transistor 102, en dimensionnant en conséquence cet interrupteur ou transistor 102, pour obtenir une valeur V2 visée.

Dans des variantes de réalisation décrites ci-après, il est souhaitable de pouvoir désactiver le dispositif 1 tel que décrit en relation avec les figures 1 à 4, en particulier lorsque que celui-ci est utilisé comme pixel d'un capteur d'images. En effet, cela permet de réduire la consommation d'un système comprenant le dispositif 1, par exemple un capteur d'images, lors de phases de fonctionnement où le dispositif 1 n'est pas utilisé. En outre, dans le cas particulier d'un capteur d'images comprenant une pluralité de pixels 1, par exemple arrangés en matrice, cela permet de désactiver le ou les pixels 1 défectueux.

Dans ces variantes de réalisation, pour désactiver le dispositif 1, on prévoit d'interrompre un chemin conducteur reliant la diode 100 au rail 106 par l'intermédiaire de l'interrupteur 102. Cette interruption du chemin conducteur est conditionnée par l'état d'un signal EN de désactivation du dispositif 1. Plus particulièrement, on prévoit d'interrompre ce chemin conducteur tant que le signal EN est dans un premier état.

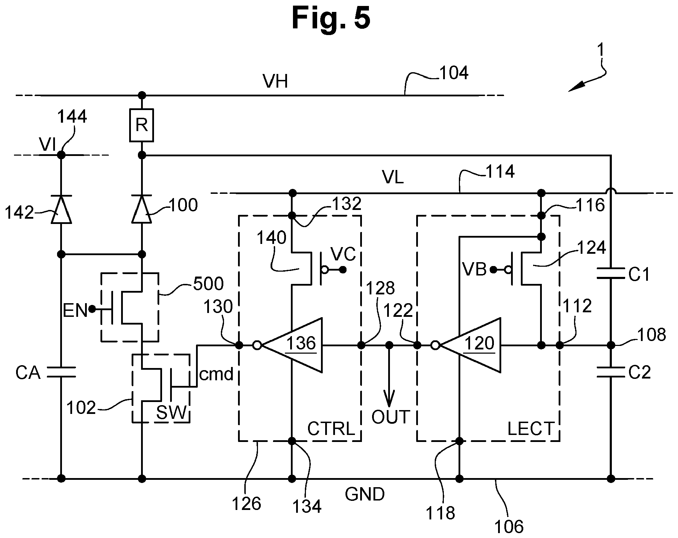

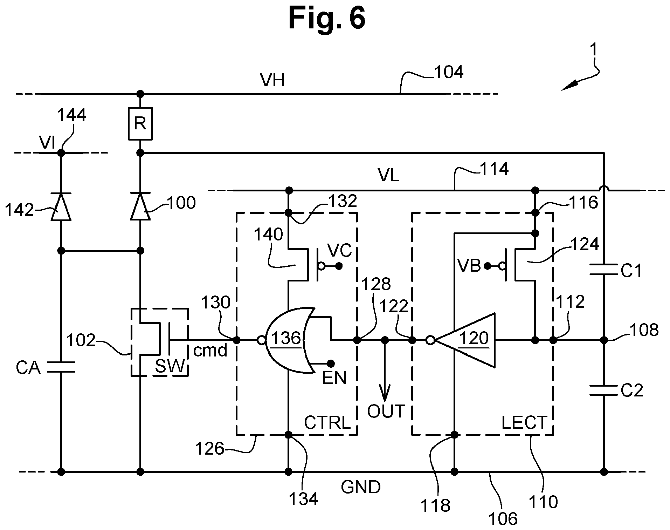

De telles variantes du dispositif 1 vont maintenant être décrites en relation avec les figures 5 et 6, seules les différences entre les dispositifs 1 des figures 5 et 6 et le dispositif 1 de la figure 1 étant ici mises en exergue.

La figure 5 illustre une variante de réalisation dans laquelle, pour interrompre le chemin conducteur reliant la diode 100 au rail 106 via l'interrupteur 102, le dispositif 1 comprend un interrupteur 500 supplémentaire.

L'interrupteur 500 est de préférence un transistor MOS 500, de préférence un transistor MOS 500 à canal N. L'interrupteur 500 est connecté en série avec l'interrupteur 102, entre la diode 100 et le rail 106. En outre, l'interrupteur 500 est commandé par le signal EN, une borne de commande de l'interrupteur 500, par exemple la grille du transistor MOS 500, étant configurée pour recevoir le signal EN. L'interrupteur 500 est configuré pour être ouvert quand le signal EN est dans un premier état, et fermé quand le signal EN est dans un deuxième état.

Dans l'exemple de la figure 5, l'interrupteur 500 est connecté entre la diode 100 et l'interrupteur 102. Dit autrement, une borne de conduction de l'interrupteur 500, par exemple le drain du transistor 500, est reliée, de préférence connectée, à la diode 100, plus particulièrement à l'anode de la diode 100, et une autre borne de conduction de l'interrupteur 500, par exemple la source du transistor 500, est reliée, de préférence connectée, à une borne de conduction de l'interrupteur 102, par exemple le drain du transistor 102.

Dans un autre exemple non illustré, l'interrupteur 500 est connecté entre l'interrupteur 102 et le rail 106. Dit autrement, une borne de conduction de l'interrupteur 500, par exemple le drain du transistor 500, est reliée, de préférence connectée, à une borne de conduction de l'interrupteur 102, par exemple la source du transistor 102, et une autre borne de conduction de l'interrupteur 500, par exemple la source du transistor 500, est reliée, de préférence connectée, au rail 106.

Le choix de la position de l'interrupteur 500 par rapport à l'interrupteur 102 est par exemple déterminé par le niveau de potentiel disponible pour le premier état du signal EN. Par exemple, dans le cas où l'on souhaite mettre en veille un système tel qu'un capteur d'images comprenant une pluralité de pixels 1, par exemple agencés en matrice, de manière à réduire au maximum la consommation du système, ce niveau de potentiel peut avoir une valeur très proche de la tension de seuil du transistor 500, par exemple de l'ordre de 0,7 V, et l'interrupteur 500 est alors préférentiellement disposé du côté du rail 106 plutôt que du côté de la diode 100. A l'inverse, quand la valeur du potentiel VL est relativement proche de la tension de seuil du transistor 102, il est souhaitable que l'interrupteur 500 soit disposé du côté de la diode 100, et que le niveau de potentiel correspondant au premier état du signal EN soit adapté en conséquence.

La figure 6 illustre une variante de réalisation dans laquelle le circuit de lecture 126 est configuré pour interrompre le chemin conducteur reliant la diode 100 au rail 106 via l'interrupteur 102 tant que le signal EN est dans un premier état. Dit autrement, le circuit 126 est configuré pour maintenir l'interrupteur 102 ouvert tant que le signal EN est dans son premier état.

Plus particulièrement, en figure 6, la porte 136 du circuit 126, par exemple une porte NON OU ("NOR"), comprend une entrée supplémentaire configurée pour recevoir le signal EN en plus de l'entrée reliée, de préférence connectée, à l'entrée 128 du circuit 126. La porte 136 est configurée pour maintenir le signal cmd dans son deuxième état (interrupteur 102 ouvert), tant que le signal EN est dans son premier état.

On notera que, par rapport à la variante de réalisation de la figure 5 dans laquelle, de préférence, les premier et deuxième états du signal EN correspondent aux états respectivement bas et haut du signal EN, dans la variante de réalisation particulière de la figure 6 où la porte 136 est une porte NON OU ("NOR"), les premier et deuxième états du signal EN correspondent aux états respectivement haut et bas du signal EN. A titre d'exemple, l'état haut du signal EN correspond à un potentiel sensiblement égal au potentiel VL, l'état bas du signal EN correspondant par exemple au potentiel GND.

Dans une autre variante de réalisation non illustrée, quand le signal EN est à son premier état, le chemin conducteur reliant la diode 100 et le rail 106 via l'interrupteur 102 est interrompu par le circuit 126 en forçant le potentiel VC à une valeur telle que le transistor MOS 140 est bloqué. Dit autrement, le signal VC est soit utilisé comme signal analogique dont la valeur conditionne la pente du signal cmd lors d'une commutation au premier état du signal cmd, soit comme signal numérique commandant la commutation à l'état bloqué du transistor 140.

Dans ce cas, après une commutation au deuxième état du signal cmd (interrupteur 102 ouvert), tant que le transistor MOS 140 est maintenu bloqué par le signal VC, aucune commutation au premier état du signal cmd n'est possible. Dit autrement, le signal VC est à une valeur telle que la pente du signal cmd est nulle lors d'une commutation de son deuxième état vers son premier état.

Dans encore une autre variante non illustrée pour laquelle le circuit 126 n'est pas configuré pour contrôler la pente du signal cmd lors des commutations entraînant la fermeture de l'interrupteur 102, le transistor 140 est commandé uniquement par le signal EN, de manière similaire à ce qui a été décrit ci-dessus.

Dans d'autres variantes de réalisation décrites ci-après, il peut également être souhaitable de désactiver uniquement le circuit 126 du dispositif 1 tel que décrit en relation avec les figures 1 à 6. Dans ces variantes, le circuit 126 est alors configuré pour maintenir l'interrupteur 102 fermé tant qu'un signal ACT de désactivation du circuit 126 est dans un premier état.

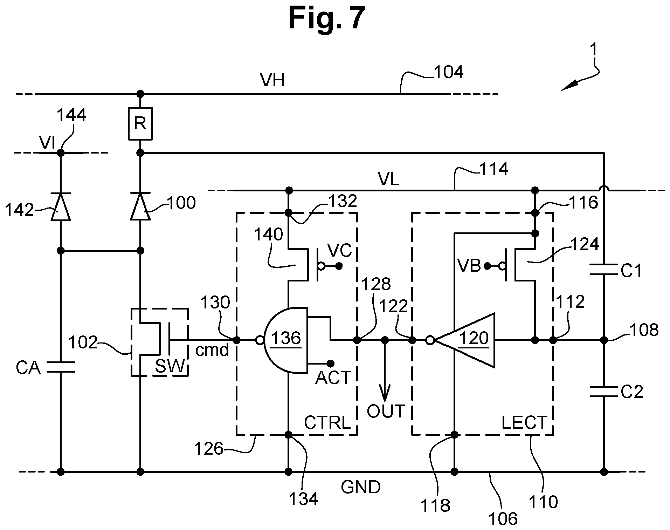

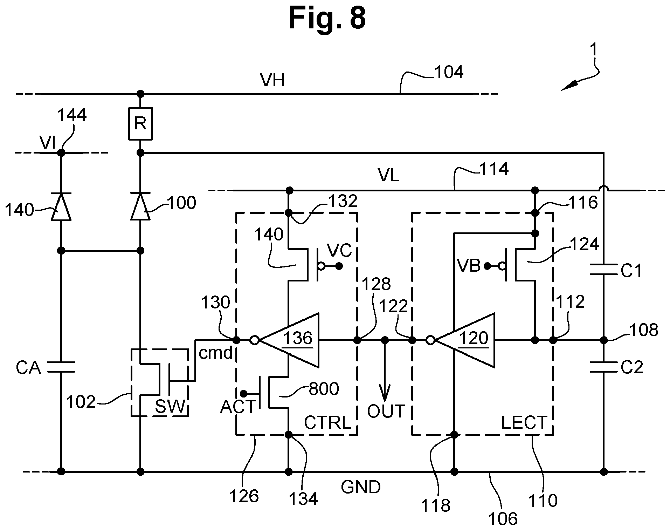

De telles variantes du dispositif 1 vont maintenant être décrites en relation avec les figures 7 et 8, seules les différences entre les dispositifs 1 des figures 7 et 8 et le dispositif 1 de la figure 1 étant ici mises en exergue.

La figure 7 illustre une variante de réalisation dans laquelle la porte 136 du circuit 126, par exemple une porte NON ET ("NAND"), comprend une entrée supplémentaire configurée pour recevoir le signal ACT en plus de l'entrée reliée, de préférence connectée, à l'entrée 128 du circuit 126. La porte 136 est configurée pour maintenir le signal cmd dans son premier état (interrupteur 102 fermé), tant que le signal ACT est dans son premier état. Dans l'exemple de la figure 7, le premier état du signal ACT correspond à un état bas du signal ACT, par exemple au potentiel GND.

La figure 8 illustre une variante de réalisation dans laquelle le circuit 126 comprend un transistor MOS 800, par exemple un transistor MOS à canal N. Le transistor 800 est connecté entre la borne 134 du circuit 126 et une borne d'alimentation correspondante de la porte 136, c'est-à-dire la borne d'alimentation de la porte 136 configurée pour recevoir le niveau de potentiel correspondant au deuxième état du signal cmd (interrupteur ouvert). Par exemple, le drain du transistor 800 est connecté à cette borne d'alimentation de la porte 136, et la source du transistor 800 est connectée à la borne 134 du circuit 126.

Le transistor 800 est commandé par le signal ACT, sa grille étant configurée pour recevoir le signal ACT. Le transistor 800 est en outre configuré pour être ouvert tant que le premier état du signal ACT, par exemple l'état bas du signal ACT, est appliqué sur sa grille. Ainsi, tant que le transistor MOS 800 est maintenu bloqué par le premier état du signal ACT, aucune commutation au deuxième état du signal cmd n'est possible et l'interrupteur 102 reste fermé.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les variantes de réalisation dans lesquelles le circuit de lecture 126 peut être désactivé peuvent être combinées avec les variantes de réalisation dans lesquelles le dispositif 1 peut être désactivé. L'homme du métier est en mesure de mettre en oeuvre ces combinaisons, notamment en modifiant la porte 136 du dispositif 1, par exemple en prévoyant une porte logique 136 comprenant trois entrées configurées pour recevoir les signaux respectifs OUT, ACT et EN.

Plus généralement, l'homme du métier peut mettre en oeuvre les fonctions du circuit 126 décrit ci-dessus en utilisant d'autres portes logiques 136 que celles décrites en relation avec les figures respectives 1 et 5 à 8, notamment une porte logique correspondant à une combinaison de plusieurs portes logiques élémentaires OU ("OR"), ET ("AND"), NON OU ("NOR"), NON ET ("NAND"), OU exclusif ("XOR"), inverseuse, etc.

Par ailleurs, on comprendra que chacune des capacités CA, C1, et C2 peut correspondre à un ou plusieurs composants capacitifs, ou à une combinaison d'un ou plusieurs composants capacitifs avec une ou plusieurs capacités intrinsèques du circuit. De manière similaire, la résistance R peut correspondre à un ou plusieurs composants résistifs, ou à une combinaison d'un ou plusieurs composants résistifs avec la résistance équivalente du conducteur électrique entre le rail 104 et le noeud 108.

En outre, bien que l'on ait indiqué précédemment que le signal OUT constitue le signal de sortie du dispositif 1, un autre signal du dispositif pourrait être utilisé comme signal de sortie. Par exemple, le signal de sortie du dispositif 1 peut correspondre à la sortie d'un inverseur dont l'entrée est reliée, par exemple connectée, à l'anode de la photodiode 100.

Enfin, la mise en oeuvre pratique des modes de réalisation et variantes décrits est à la portée de l'homme du métier à partir des indications fonctionnelles données ci-dessus.

## Revendications

1. Dispositif (1) comprenant :
une photodiode (100) dont une première borne est reliée par une résistance (R) à un premier noeud (104) configuré pour recevoir un potentiel haut d'alimentation (VH) et dont une deuxième borne est reliée par un interrupteur (102), de préférence un transistor MOS, à un deuxième noeud (106) configuré pour recevoir un potentiel de référence (GND) ;
un circuit de lecture (110) configuré pour fournir une impulsion (OUT) lorsque la diode (100) entre en avalanche ;
un circuit de commande (126) configuré pour commander une ouverture de l'interrupteur (102) en réponse au début de ladite impulsion (OUT) et pour commander une fermeture de l'interrupteur en réponse à la fin de ladite impulsion (OUT) ; caractérisé en ceci qu' un pont diviseur capacitif (C1, C2) est connecté entre la première borne de la diode (100) et le deuxième noeud (106), une borne d'entrée (112) du circuit de lecture (110) étant connectée à un noeud intermédiaire (108) du pont diviseur capacitif.

2. Dispositif selon la revendication 1, dans lequel le circuit de commande (126) comprend une porte logique (136) comprenant une entrée configurée pour recevoir ladite impulsion (OUT) et une sortie (130) configurée pour fournir un signal de commande (cmd) de l'interrupteur (102).

3. Dispositif selon la revendication 2, dans lequel le circuit de commande (126) est en outre configuré pour contrôler la pente du signal de commande (cmd) en fonction d'une valeur d'un potentiel de réglage de pente (VC), lors d'une commutation du signal de commande (cmd) entraînant une fermeture l'interrupteur (102).

4. Dispositif selon la revendication 3, dans lequel le circuit de commande comprend un transistor MOS (140) connecté entre une borne d'alimentation (132) du circuit de commande (126) et une première borne d'alimentation de la porte (136) du circuit de commande (126), une grille du transistor MOS (140) étant configurée pour recevoir le potentiel de réglage de pente (VC).

5. Dispositif selon l'une quelconque des revendications 2 à 4, configuré pour interrompre un chemin conducteur reliant la deuxième borne de la diode (100) au deuxième noeud (106) via l'interrupteur (102) tant qu'un signal (EN) de désactivation du dispositif (1) est dans un premier état.

6. Dispositif selon la revendication 5, dans lequel :
- un interrupteur supplémentaire (500) commandé par le signal (EN) de désactivation du dispositif (1) est connecté en série avec ledit interrupteur (102) entre la deuxième borne de la diode (100) et le deuxième noeud (106) ; ou
- la porte (136) du circuit de commande (126) comprend une entrée configurée pour recevoir le signal (EN) de désactivation du dispositif (1).

7. Dispositif selon l'une quelconque des revendications 2 à 6, dans lequel le circuit de commande (126) est en outre configuré pour maintenir l'interrupteur (102) fermé tant qu'un signal (ACT) de désactivation du circuit de commande (126) est dans un premier état, de préférence, la porte (136) du circuit de commande (126) comprenant une entrée configurée pour recevoir le signal (ACT) de désactivation du circuit de commande (126).

8. Dispositif selon l'une quelconque des revendications 2 à 6, dans lequel le circuit de commande (126) comprend un transistor MOS (800) connecté entre une deuxième borne d'alimentation de la porte (126) du circuit de commande et le deuxième noeud (106), une grille du transistor étant configurée pour recevoir un signal (ACT) de désactivation du circuit de commande (126).

9. Dispositif selon l'une quelconque des revendications 1 à 8, dans lequel le circuit de lecture (110) est en outre configuré pour modifier une durée de l'impulsion (OUT) en fonction d'une valeur d'un potentiel (VA) de réglage de durée d'impulsion.

10. Dispositif selon la revendication 9, dans lequel le circuit de lecture (110) comprend un transistor MOS (124) connecté entre une borne d'alimentation (116) du circuit de lecture (110) et le noeud intermédiaire (108), une grille du transistor MOS (124) étant configurée pour recevoir le potentiel (VB) de réglage de durée d'impulsion.

11. Dispositif selon l'une quelconque des revendications 1 à 10, dans lequel le circuit de lecture (110) comprend une porte logique (120), de préférence un inverseur, comprenant une borne d'entrée reliée, de préférence connectée, au noeud intermédiaire (108), et une borne de sortie (122) configurée pour fournir ladite impulsion (OUT).

12. Dispositif selon l'une quelconque des revendications 1 à 11, dans lequel le circuit de lecture (110) et le circuit de commande (126) sont connectés chacun entre le deuxième noeud (106) et un troisième noeud (114) configuré pour recevoir un potentiel bas d'alimentation (VL).

13. Dispositif selon l'une quelconque des revendications 1 à 12, comprenant en outre un circuit (142) de limitation de potentiel configuré pour limiter un niveau maximal de potentiel sur la deuxième borne de la diode (100), de préférence, le circuit de limitation de potentiel comprenant une diode supplémentaire (142) connectée entre la deuxième borne de ladite diode (100) et un noeud (144) configuré pour recevoir un potentiel intermédiaire d'alimentation (VI).

14. Dispositif selon l'une quelconque des revendications 1 à 13, comprenant en outre une capacité (CA) connectée entre la deuxième borne de ladite diode (100) et le deuxième noeud (106).

15. Capteur d'images comprenant une pluralité de dispositifs (1) selon l'une quelconque des revendications 1 à 14, de préférence agencés en matrice, chaque dispositif (1) formant de préférence un pixel du capteur.

## Patentansprüche

1. Vorrichtung (1), die Folgendes aufweist:
eine Fotodiode (100), deren erster Anschluss über einen Widerstand (R) mit einem ersten Knoten (104) gekoppelt ist, der konfiguriert ist zum Empfangen eines hohen Versorgungspotenzials (VH), und deren zweiter Anschluss über einen Schalter (102), vorzugsweise einen MOS-Transistor, mit einem zweiten Knoten (106) gekoppelt ist, der konfiguriert ist zum Empfangen eines Referenzpotenzials (GND);
eine Leseschaltung (110), die konfiguriert ist zum Liefern eines Impulses (OUT), wenn die Diode (100) in einen Lawinendurchbruch eintritt; und
eine Steuerschaltung (126), die konfiguriert ist zum Steuern des Öffnens des Schalters (102) ansprechend auf den Beginn des Impulses und zum Steuern des Schließens des Schalters (OUT) ansprechend auf das Ende des Impulses (OUT); **dadurch gekennzeichnet, dass** eine kapazitive Teilerbrücke (C1, C2) zwischen dem ersten Anschluss der Diode (100) und dem zweiten Knoten (106) verbunden ist, und ein Eingangsanschluss (112) der Leseschaltung (110) mit einem Zwischenknoten (108) der kapazitiven Teilerbrücke verbunden ist.

2. Vorrichtung nach Anspruch 1, wobei die Steuerschaltung (126) ein Logik-Gatter (136) aufweist, mit einem Eingang, der konfiguriert ist zum Empfangen des Impulses (OUT), und einem Ausgang (130), der konfiguriert ist zum Liefern eines Steuersignals (cmd) des Schalters (102).

3. Vorrichtung nach Anspruch 2, wobei die Steuerschaltung (126) ferner konfiguriert ist zum Steuern der Steigung des Steuersignals (cmd) als Funktion eines Werts eines Steigungseinstellungspotenzials (VC), während ein Schalten des Steuersignals (cmd) ein Schließen des Schalters (102) bewirkt.

4. Vorrichtung nach Anspruch 3, wobei die Steuerschaltung einen MOS-Transistor (140) aufweist, der zwischen einem Versorgungsanschluss (132) der Steuerschaltung (126) und einem ersten Versorgungsanschluss des Gatters (136) der Steuerschaltung (126) angeschlossen ist, wobei ein Gate des MOS-Transistors (140) konfiguriert ist zum Empfangen des Neigungseinstellungspotenzials (VC).

5. Vorrichtung nach einem der Ansprüche 2 bis 4, die konfiguriert ist zum Unterbrechen eines Leitungspfad, der den zweiten Anschluss der Diode (100) mit dem zweiten Knoten (106) koppelt, und zwar über den Schalter (102) und so lange, wie sich ein Signal (EN) zur Deaktivierung der Vorrichtung (1) in einem ersten Zustand befindet.

6. Die Vorrichtung nach Anspruch 5, wobei:
- ein zusätzlicher Schalter (500), der durch das Signal (EN) zum Deaktivieren der Vorrichtung (1) gesteuert wird, in Reihe mit dem Schalter (102) zwischen dem zweiten Anschluss der Diode (100) und dem zweiten Knoten (106) verbunden ist; oder
- das Gatter (136) der Steuerschaltung (126) einen Eingang aufweist, der konfiguriert ist zum Empfangen des Signals (EN) zum Deaktivieren der Vorrichtung (1).

7. Vorrichtung nach einem der Ansprüche 2 bis 6, wobei die Steuerschaltung (126) ferner konfiguriert ist zum Geschlossen-Halten des Schalters (102) und zwar so lange, wie sich ein Signal (ACT) zum Deaktivieren der Steuerschaltung (126) in einem ersten Zustand befindet, wobei vorzugsweise das Gatter (136) der Steuerschaltung (126) einen Eingang aufweist, der konfiguriert ist zum Empfangen des Signals (ACT) zum Deaktivieren der Steuerschaltung (126).

8. Vorrichtung nach einem der Ansprüche 2 bis 6, wobei die Steuerschaltung (126) einen MOS-Transistor (800) aufweist, der zwischen einem zweiten Versorgungsanschluss des Gatters (126) der Steuerschaltung und dem zweiten Knoten (106) verbunden ist, wobei ein Gate des Transistors konfiguriert ist zum Empfangen des eines Signal (ACT) zum Deaktivieren der Steuerschaltung (126).

9. Vorrichtung nach einem der Ansprüche 1 bis 8, wobei die Leseschaltung (110) ferner konfiguriert ist zum Modifizieren einer Dauer des Impulses (OUT) in Abhängigkeit von einem Wert eines Impulsdauer-Einstellpotenzials (VA).

10. Vorrichtung nach Anspruch 9, wobei die Leseschaltung (110) einen MOS-Transistor (124) aufweist, der zwischen einem Versorgungsanschluss (116) der Leseschaltung (110) und dem Zwischenknoten (108) verbunden ist, wobei ein Gate des MOS-Transistors (124) konfiguriert ist zum Empfangen des Impulsdauer-Einstellpotenzials (VB).

11. Vorrichtung nach einem der Ansprüche 1 bis 10, wobei die Leseschaltung (110) ein logisches Gatter (120) aufweist, vorzugsweise einen Inverter, aufweisend einen Eingangsanschluss, der mit dem Zwischenknoten (108) gekoppelt, vorzugsweise verbunden, ist, und einen Ausgangsanschluss (122), der konfiguriert ist zum Liefern des Impulses (OUT) liefert.

12. Vorrichtung nach einem der Ansprüche 1 bis 11, wobei die Leseschaltung (110) und die Steuerschaltung (126) jeweils zwischen dem zweiten Knoten (106) und einem dritten Knoten (114) angeschlossen sind, der konfiguriert ist zum Empfangen eines niedrigen Versorgungspotentials (VL).

13. Vorrichtung nach einem der Ansprüche 1 bis 12, die ferner eine Potenzialbegrenzungsschaltung (142) aufweist, die konfiguriert ist zum Begrenzen eines maximalen Potenzialpegels am zweiten Anschluss der Diode (100), wobei die Potenzialbegrenzungsschaltung vorzugsweise eine zusätzliche Diode (142) aufweist, die zwischen dem zweiten Anschluss der Diode (100) und einem Knoten (144) angeschlossen ist, der konfiguriert ist zum Empfangen eines mittleren Versorgungspotenzials (VI).

14. Vorrichtung nach einem der Ansprüche 1 bis 13, die ferner einen Kondensator (CA) aufweist, der zwischen dem zweiten Anschluss der Diode (100) und dem zweiten Knoten (106) verbunden ist.

15. Bildsensor mit einer Vielzahl von Vorrichtungen (1) nach einem der Ansprüche 1 bis 14, die vorzugsweise in einer Matrix angeordnet sind, wobei jede Vorrichtung (1) vorzugsweise ein Pixel des Sensors bildet.

## Claims

1. A device (1) comprising:
a photodiode (100) a first terminal of which is coupled by a resistor (R) to a first node (104) configured to receive a high supply potential (VH) and a second terminal of which is coupled by a switch (102), preferably a MOS transistor, to a second node (106) configured to receive a reference potential (GND);
a read circuit (110) configured to provide a pulse (OUT) when the diode (100) enters into avalanche; and
a control circuit (126) configured to control an opening of the switch (102) in response to the beginning of said pulse and to control a closing of the switch (OUT) in response to the end of said pulse (OUT); **characterized in that** a capacitive bridge divider (C1, C2) is connected between the first terminal of the diode (100) and the second node (106), an input terminal (112) of the read circuit (110) being connected to an intermediate node (108) of the capacitive divider bridge.

2. The device according to claim 1, wherein the control circuit (126) comprises a logic gate (136) comprising an input configured to receive said pulse (OUT) and an output (130) configured to provide a control signal (cmd) of the switch (102).

3. The device according to claim 2, wherein the control circuit (126) is further configured to control the slope of the control signal (cmd) as a function of a value of a slope adjustment potential (VC), during a switching of the control signal (cmd) causing a closing of the switch (102).

4. The device according to claim 3, wherein the control circuit comprises a MOS transistor (140) connected between a supply terminal (132) of the control circuit (126) and a first supply terminal of the gate (136) of the control circuit (126), a gate of the MOS transistor (140) being configured to receive the slope adjustment potential (VC).

5. The device according to any of claims 2 to 4, configured to interrupt a conductive path coupling the second terminal of the diode (100) to the second node (106) via the switch (102) for as long as a signal (EN) for deactivating the device (1) is in a first state.

6. The device according to claim 5, wherein:
- an additional switch (500) controlled by the signal (EN) for deactivating the device (1) is connected in series with said switch (102) between the second terminal of the diode (100) and the second node (106); or
- the gate (136) of the control circuit (126) comprises an input configured to receive the signal (EN) for deactivating the device (1).

7. The device according to any of claims 2 to 6, wherein the control circuit (126) is further configured to keep the switch (102) closed for as long as a signal (ACT) for deactivating the control circuit (126) is in a first state, preferably, the gate (136) of the control circuit (126) comprising an input configured to receive the signal (ACT) for deactivating the control circuit (126).

8. The device according to any of claims 2 to 6, wherein the control circuit (126) comprises a MOS transistor (800) connected between a second supply terminal of the gate (126) of the control circuit and the second node (106), a gate of the transistor being configured to receive a signal (ACT) for deactivating the control circuit (126).

9. The device according to any of claims 1 to 8, wherein the read circuit (110) is further configured to modify a duration of the pulse (OUT) as a function of a value of a pulse-duration adjustment potential (VA).

10. The device according to claim 9, wherein the read circuit (110) comprises a MOS transistor (124) connected between a supply terminal (116) of the read circuit (110) and the intermediate node (108), a gate of the MOS transistor (124) being configured to receive the pulse-duration adjustment potential (VB).

11. The device according to any of claims 1 to 10, wherein the read circuit (110) comprises a logic gate (120), preferably an inverter, comprising an input terminal coupled, preferably connected, to the intermediate node (108), and an output terminal (122) configured to provide said pulse (OUT).

12. The device according to any of claims 1 to 11, wherein the read circuit (110) and the control circuit (126) are each connected between the second node (106) and a third node (114) configured to receive a low supply potential (VL) .

13. The device according to any of claims 1 to 12, further comprising a potential-limiting circuit (142) configured to limit a maximum level of potential on the second terminal of the diode (100), the potential-limiting circuit preferably comprising an additional diode (142) connected between the second terminal of said diode (100) and a node (144) configured to receive an intermediate supply potential (VI).

14. The device according to any of claims 1 to 13, further comprising a capacitor (CA) connected between the second terminal of said diode (100) and the second node (106).

15. An image sensor comprising a plurality of devices (1) according to any of claims 1 to 14, preferably arranged in a matrix, each device (1) preferably forming a pixel of the sensor.
